Europäisches Patentamt

European Patent Office

Office européen des brevets

(19)

(11) Veröffentlichungsnummer: **0 215 288**
**B1**

(12) # EUROPÄISCHE PATENTSCHRIFT

(45) Veröffentlichungstag der Patentschrift:
13.06.90

(21) Anmeldenummer: 86111085.6

(22) Anmeldetag: 11.08.86

(51) Int. Cl.⁵: **H03K 19/096**, H03K 19/017,
H03K 5/02, H03K 3/356

(54) **Signalumsetzschaltung.**

(30) Priorität: 13.08.85 DE 3529047

(43) Veröffentlichungstag der Anmeldung:
25.03.87 Patentblatt 87/13

(45) Bekanntmachung des Hinweises auf die Patenterteilung:
13.06.90 Patentblatt 90/24

(84) Benannte Vertragsstaaten:
AT BE CH DE FR GB IT LI NL SE

(56) Entgegenhaltungen:
EP-A- 0 110 060
DE-A- 2 840 329
DE-A- 3 220 063
DE-A- 3 324 030

IBM TECHNICAL DISCLOSURE BULLETIN, Band 27,
Nr. 10B, März 1985, Seiten 6023, 6024; "Receiver for
clocked or pseudo-clocked cascode voltage switch
logic"

(73) Patentinhaber: Siemens Aktiengesellschaft,
Wittelsbacherplatz 2, D-8000 München 2(DE)

(72) Erfinder: Hofmann, Rüdiger, Dr., Fürstenfelder Weg 12,
D-8031 Gilching(DE)

**Beschreibung**

Die Erfindung betrifft eine Signalumsetzschaltung.

Bei hoch- und höchstintegrierten (VLSI-)Bausteinen tritt häufig das Problem auf, daß angelieferte kleinhubige Eingangssignale, beispielsweise TTL-Signale, in großhubige Ausgangssignale, beispielsweise Signale zum Ansteuern von C-MOS-Bausteinen, umgesetzt werden müssen.

Zur Umsetzung eines TTL-Taktsignals in ein MOS-Taktsignal ist (aus DE-A 3 220 063) eine Taktumsetzschaltung bekannt, die eine TTL-Eingangsinverterstufe, eine Rücksetztaktstufe mit drei Invertern und eine Leistungstaktstufe aufweist, die ihrerseits aus einer Schaltstufe, einer Verzögerungsstufe mit zwei Invertern und einer Endstufe mit ebenfalls zwei Invertern besteht, wobei die Rücksetztaktstufe und die Leistungsstufe direkt von der Eingangsinverterstufe aktiviert werden und die Rücksetztaktstufe zwei Rücksetzsignale an die Leistungsstufe liefert. Diese bekannte Signalumsetzschaltung, die an sich eine relativ verlustleistungsarme Taktumsetzung in großhubige Taktsignale mit steilen Signalflanken bei hoher Belastung ermöglicht, ist in ihrer Empfindlichkeit und damit in ihrer Schnelligkeit insofern begrenzt, als sie auf Änderungen des Eingangssignals jeweils erst dann reagiert, wenn dieses mit seiner jeweiligen Signalflanke eine Ansprechschwelle in Höhe der (üblicherweise bei 2,5 Volt liegenden) halben Drain-Source-Speisespannung über- bzw. unterschritten hat.

Zur Signalumsetzung von TTL-Pegeln auf CMOS-Pegel ist (aus IBM Techn. Discl. Bull. Vol.27, No.10B, March 1985, p.p. 6023-6024) eine Signalumsetzschaltung mit einer Flip-Flop-Schaltung und einer Taktsteuerschaltung, durch die taktflankengesteuert ein dem Binärwert eines Eingangssignals entsprechender Zustand in der Flip-Flop-Schaltung eingestellt wird, bekannt, wobei der Flip-Flop-Schaltung eine Leistungsstufe mit zwei CMOS-Inverterschaltungen nachgeschaltet ist. Diese bekannte Schaltungsanordnung, die einen entsprechenden Binärwert eines Eingangssignals mit einer Taktflanke durch ungleiche Strombeaufschlagung der beiden Zweige des Flip-Flops als einen diesem Binärwert zugeordneten Zustand des Flip-Flops übernimmt, ist indessen ebenfalls relativ langsam und außerdem mit statischer Verlustleistung behaftet, was sich insbesondere dann als nachteilig erweist, wenn ein Chip eine Vielzahl solcher Pegelumsetzschaltungen benötigt.

Demgegenüber stellt sich die Erfindung die Aufgabe, eine merklich empfindlichere und damit schnellere Signalumsetzschaltung anzugeben.

Die Erfindung betrifft eine Schaltungsanordnung zur Umsetzung von kleinhubigen Eingangssignalen in großhubige Ausgangssignale mit einer Flip-Flop-Schaltung und einer Taktsteuerschaltung, durch die taktflankengesteuert ein dem Binärwert eines Eingangssignals entsprechender Zustand der Flip-Flop-Schaltung eingestellt wird, wobei der Flip-Flop-Schaltung eine Leistungsstufe mit zwei C-MOS-Inverterschaltungen nachgeschaltet ist, insbesondere zum Ansteuern von C-MOS-Bausteinen mit TTL- oder ECL-Signalen. Diese Schaltungsanordnung ist erfindungsgemäß gekennzeichnet durch zwei kreuzgekoppelte C-MOS-Inverterschaltungen,

– an deren zwei Ausgänge die eine Speisepotentialquelle auch gleichzeitig über zwei gleichsinnig taktsignalgesteuerte Schalttransistoren des einen Kanaltyps anschaltbar ist,
und eine zwischen deren zwei Transistoren des anderen Kanaltyps und die andere Speisepotentialquelle eingefügte Ansteuerschaltung mit
– zwei weiteren, zwischen diese Transistoren und die Speisepotentialquelle eingefügten Transistoren gleichen Typs,
– einer dem einen dieser zwei weiteren Transistoren parallelgeschalteten Serienschaltung aus einem eingangssignalgesteuerten MOS-Transistor gleichen Typs und einem taktsignalgesteuerten MOS-Transistor gleichen Typs
– und einem zwischen den zwei Verbindungspunkten der zwei kreuzgekoppelten C-MOS-Inverterschaltungen und der Ansteuerschaltung eingefügten Transistor gleichen Typs, über den die zwei kreuzgekoppelten C-MOS-Inverterschaltungen zu einem bistabilen Kippglied zusammenschaltbar sind.

Die Signalumsetzschaltung gemäß der Erfindung bringt neben dem Vorteil, zum sicheren Betrieb nur einen einzigen Takt zu benötigen, die mit ihrer Ausbildung als dynamisch betriebene Schaltung verbundenen weiteren Vorteile einer hohen, lediglich durch die (etwa bei 0,5 bis 1,2 Volt) liegende Schwellenspannung des mit dem Eingangssignal beaufschlagten MOS-Transistors bestimmten Empfindlichkeit und kurzer Einstellzeiten mit sich, die sich je nach der Dimensionierung im Bereich einiger bis zu etwa 10 Nanosekunden bewegen mögen.

Dabei kann die Signalumsetzschaltung an verschiedene Ansteuerbedingungen angepaßt sein:

So kann in weiterer Ausgestaltung der Erfindung bei unterschiedlicher Dimensionierung der genannten zwei weiteren Transistoren dem Transistor höheren Kanalwiderstands die genannte Serienschaltung zweier MOS-Transistoren parallelgeschaltet sein, was eine einfache Ansteuerung nur mit dem Eingangssignal ermöglicht.

Soll das Eingangssignal mit einem einen Entscheidungspegel definierenden externen Referenzsignal verglichen werden, so kann in weiterer Ausgestaltung der Erfindung bei gleicher Dimensionierung der genannten zwei weiteren Transistoren dem anderen dieser zwei Transistoren eine Serienschaltung aus einem zusatzsignalgesteuerten MOS-Transistor gleichen Typs und einem taktsignalgesteuerten MOS-Transistor gleichen Typs parallelgeschaltet sein, wobei der zusatzsignalgesteuerte MOS-Transistor durch das Referenzsignal gesteuert wird.

Liegt das Eingangssignal auch als Komplementärsignal vor, so kann in weiterer Ausgestaltung der Erfindung bei gleicher Dimensionierung der genannten zwei weiteren Transistoren dem anderen dieser zwei Transistoren eine Serienschaltung aus einem zusatzsignalgesteuerten MOS-Transistor gleichen Typs und einem taktsignalgesteuerten MOS-Transistor gleichen Typs parallelgeschaltet sein, wobei der zusatzsignalgesteuerte MOS-Transistor durch das negierte Eingangssignal gesteuert wird.

Um auch bei größeren (kapazitiven) Ausgangslasten deren Einfluss auf die Signalumsetzung gering zu halten, kann in weiterer Ausgestaltung der Erfindung der Leistungsstufe eine Ausgangsstufe mit zwei mit den genannten zwei weiteren C-MOS-Inverterschaltungen verbundenen Einkanal-MOS-Gegentakt-Ausgangsschaltungen nachgeschaltet sein; alternativ dazu ist es auch möglich, daß der Leistungsstufe eine Ausgangsstufe mit zwei mit den genannten zwei weiteren C-MOS-Inverterschaltungen verbundenen Einkanal-MOS-Sourcefolger-Ausgangsschaltungen mit Flip-Flop-Rückkopplung ihrer Treibertransistoren nachgeschaltet ist. Um der bei einer Ansteuerung dynamisch betriebener Schaltungen manchmal bestehenden Forderung Rechnung zu tragen, daß in Taktpausen beide Komplementärausgänge der Schaltungsanordnung ein "0"-Signal führen, kann dabei die Schaltungsanordnung in weiterer Ausgestaltung der Erfindung dahingehend ausgebildet sein, daß ihren beiden Komplementärausgängen gleichzeitig das dem einen Signalzustand entsprechende Ausgangssignal über zwei mit dem negierten Taktsignal gesteuerte Schalttransistoren aufprägbar ist.

Anhand der Zeichnung sei die Erfindung noch näher erläutert. Dabei zeigt

FIG 1 ein Ausführungsbeispiel einer Signalumsetzschaltung gemäß der Erfindung;
FIG 2 läßt den Signalverlauf an den entsprechend bezeichneten Schaltungspunkten erkennen.
FIG 3 und FIG 4 zeigen weitere Ausgestaltungen der Schaltungsanordnung nach FIG 1; in
FIG 5 wird eine Modifikation ihrer Ansteuerschaltung verdeutlicht.

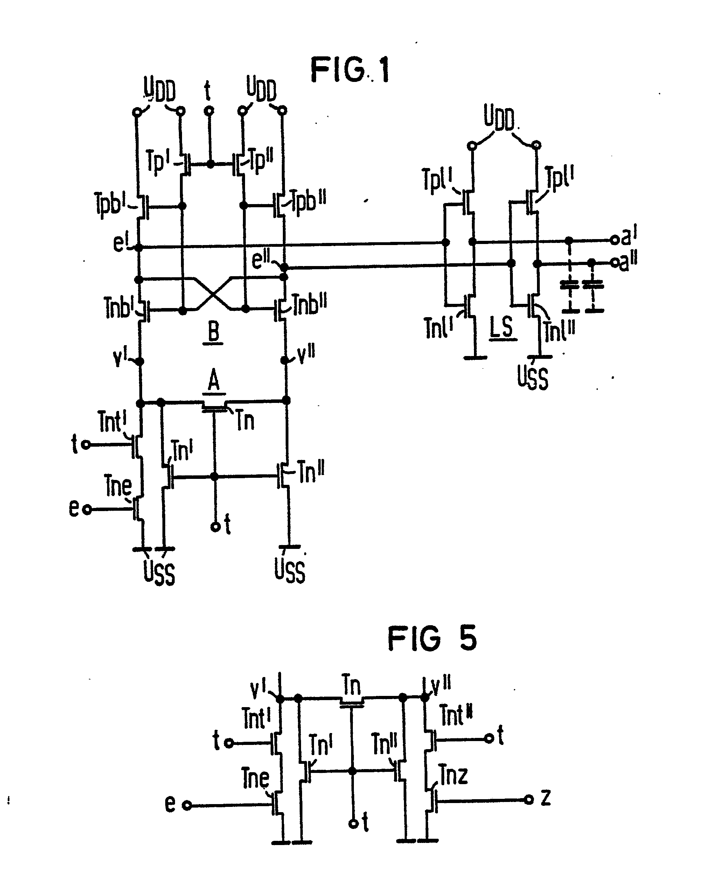

Die in FIG 1 skizzierte Signalumsetzschaltung weist zunächst ein - als solches nicht ständig wirksamgeschaltetes - bistabiles Kippglied B mit zwei kreuzgekoppelten C-MOS-Inverterschaltungen Tpb', Tnb' und Tpb", Tnb" auf, an deren zwei Ausgänge e' und e" die eine Speisepotentialquelle $U_{DD}$ auch gleichzeitig über zwei gleichsinnig taktsignalgesteuerte Schalttransistoren Tp' und Tp" des einen Kanaltyps - im Ausführungsbeispiel: p-Kanal-(Verarmungs-)Transistor - anschaltbar ist. Zwischen die zwei Transistoren Tnb' und Tnb" des anderen Kanaltyps - im Ausführungsbeispiel: n-Kanal-(Anreicherungs-)-Transistor - und die andere Speisepotentialquelle $U_{SS}$ ist eine Ansteuerschaltung A mit zwei weiteren, zwischen diese Transistoren Tnb', Tnb" und die Speisepotentialquelle $U_{SS}$ eingefügten Transistoren Tn', Tn" gleichen Typs und einer dem einen dieser zwei weiteren Transistoren, nämlich dem Transistor Tn', parallelgeschalteten Serienschaltung aus einem eingangssignalgesteuerten MOS-Transistor Tne gleichen Typs und einem taktsignalgesteuerten MOS-Transistor Tnt' gleichen Typs eingefügt; zwischen den zwei Verbindungspunkten v', v" der zwei kreuzgekoppelten C-MOS-Inverterschaltungen Tpb', Tnb' und Tpb", Tnb" und der Ansteuerschaltung A ist ein Transistor Tn gleichen Typs eingefügt, über den die zwei kreuzgekoppelten C-MOS-Inverterschaltungen zum bistabilen Kippglied zusammenschaltbar sind. Schließlich ist den zwei kreuzgekoppelten C-MOS-Inverterschaltungen Tpb', Tnb' und Tpb, Tnb" eine Leistungsstufe LS mit zwei weiteren C-MOS-Inverterschaltungen Tpl', Tnl' und Tpl", Tnl" nachgeschaltet.

An ihren Betriebsspannungsklemmen $U_{DD}$ möge der in FIG 1 skizzierten Signalumsetzschaltung ein Speisepotential von beispielsweise +5 Volt gegenüber dem an den Betriebsspannungsklemmen $U_{SS}$ (Masse) gegebenen Potential zugeführt werden; von den genannten zwei weiteren Transistoren Tn' und Tn" möge der Transistor Tn', dem die Serienschaltung der beiden MOS-Transistoren Tne und Tnt' parallelgeschaltet ist, durch entsprechende Dimensionierung einen höheren Kanalwiderstand haben als der weitere Transistor Tn", so daß die Parallelschaltung aus dem Transistor Tn' und der Transistor-Reihenschaltung Tnt', Tne bei einem an dem zur Gate-Elektrode des Eingangssignaltransistors Tne führenden Schaltungseingang e anliegenden Potential von weniger als etwa 0,8 Volt über $U_{SS}$ (Masse) einen höheren Widerstand und bei einem am Schaltungseingang e anliegenden Potential von mehr als etwa 1,5 Volt über $U_{SS}$ (Masse) einen niedrigeen Widerstand als der weitere Transistor Tn" bildet.

Die in FIG 1 skizzierte Signalumsetzschaltung arbeitet dann wie folgt:

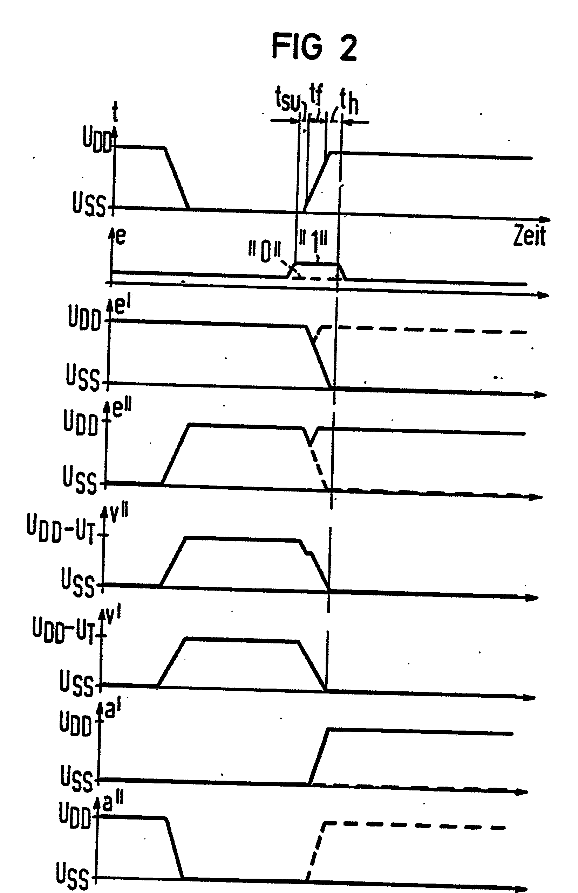

Es sei angenommen, daß - aufgrund eines (früheren) Eingangssignals e (in FIG 2e) von höchstens etwa 0,8 Volt - bei einem an den Takteingängen t (in FIG 1) anstehenden Taktsignal gemäß FIG 2t vom Potentialwert $U_{DD}$ (+5 Volt) in den zu einem bistabilen Kippglied B geschalteten zwei kreuzgekoppelten C-MOS-Inverterschaltungen Tpb', Tnb' und Tpb", Tnb" der p-Kanal-Transistor Tpb' der einen Inverterschaltung und der n-Kanal-Transistor Tnb" der anderen Inverterschaltung leitend und der n-Kanal-Transistor Tnb' der einen Inverterschaltung und der p-Kanal-Transistor Tpb" der anderen Inverterschaltung nichtleitend sind, so daß am Inverterausgang e' der einen C-MOS-Inverterschaltung das $U_{DD}$-Potential (+5 Volt) auftritt und am Inverterausgang e" der anderen C-MOS-Inverterschaltung

EP 0 215 288 B1

das - bei leitenden Transistoren Tn" und Tn', Tnt', Tne der Ansteuerschaltung A an deren Verbindungspunkt v" (ebenso wie am Verbindungspunkt v') mit dem bistabilen Kippglied B gegebene - $U_{SS}$ -Potential (Masse).

Bei dieser Konstellation sind in der Leistungsstufe LS der p-Kanal-Transistor Tpl' der einen C-MOS-Inverterschaltung Tpl', Tnl' und der n-Kanal-Transistor Tnl" der anderen C-MOS-Inverterschaltung Tpl", Tnl" nichtleitend und der n-Kanal-Transistor Tnl' der einen C-MOS-Inverterschaltung und der p-Kanal-Transistor Tpl" der anderen C-MOS-Inverterschaltung leitend; am Ausgang a'der Schaltungsanordnung tritt dann gemäß FIG 2a' ein 0"-Ausgangssignal $U_{SS}$ (Masse) auf und am Komplementärausgang a" gemäß FIG 2a" das $U_{DD}$ -Potential von +5 Volt.

Springt zu Beginn einer Signalübernahme-Vorbereitungsphase das an den Takteingängen t (in FIG 1) anstehende Taktsignal gemäß FIG 2t auf den Wert $U_{SS}$ (Masse), so werden bei dem bistabilen Kippglied B die zwei gleichsinnig taktsignalgesteuerten p-Kanal-Schalttransistoren Tp' und Tp" leitend, so daß beiden Inverterausgängen e' und e" das $U_{DD}$ -Potential (+5 Volt) aufgeprägt wird mit der Folge, daß dann in beiden C-MOS-Inverterschaltungen jeweils der p-Kanal-Transistor Tpb' bzw. Tpb" nichtleitend und der n-Kanal-Transistor Tnb' bzw. Tnb" leitend ist. An beiden Verbindungspunkten v' und v" zwischen dem (bisherigen) bistabilen Kippglied B und der Ansteuerschaltung A ist dann bei einer Schwellenspannung $U_T$ der n-Kanal-Transistoren Tnb', Tnb" von beispielsweise 1 Volt ein Potential $U_{DD} - U_T$ von beispielsweise +4 Volt gegeben; dabei sind in der Ansteuerschaltung A zumindest die Transistoren Tn, Tn", Tn' und Tnt' nichtleitend.

Bei dieser Konstellation sind in der Leistungsstufe LS beide p-Kanal-Transistoren Tpl' und Tpl" nichtleitend und beide n-Kanal-Transistoren Tnl' und Tnl" leitend, so daß an beiden Schaltungsausgängen A' und A" das $U_{SS}$-Potential (Masse) auftritt.

Die nachfolgende Signalübernahmephase beginnt mit dem Ansteigen des an den Takteingängen t (in FIG 1) auftretenden Taktsignals gemäß FIG 2t vom Potentialwert $U_{DD}$ auf den Potentialwert $U_{DD}$ ; im Verlauf des Taktsignalanstiegs wird das am Eingang e der Signalumsetzschaltung nach FIG 1 anstehende Eingangssignal, wie es in FIG 2e skizziert ist, abgetastet:

Mit zunehmendem Taktsignalpotential werden zunächst in der Ansteuerschaltung A die beiden Haltetransistoren Tn' und Tn" sowie der Abtasttransistor Tnt' leitend; dabei kommt es an den Verbindungspunkten v' und v" zu einem Stromfluß, aufgrund dessen die Potentiale an den Verbindungspunkten v' und v" abgesenkt werden. Der Verstärkertransistor Tn bleibt dabei zunächst, nämlich solange die Verbindungspunkte v' und v" auf zu hohem Potential liegen und das Taktsignalpotential noch zu niedrig ist, gesperrt, so daß die kreuzgekoppelten C-MOS-Inverter Tpb', Tnb' und Tpb", Tnb" noch nicht zu einem bistabilen Kippglied wirksamgeschaltet sind. Die über die Verbindungspunkte v' und v" zwischen dem - als solches noch nicht wirksamgeschalteten - bistabilen Kippglied B und der Ansteuerschaltung A fließenden Ströme bewirken über die n-Kanal-Transistoren Tnb' und Tnb" der beiden C-MOS-Inverterschaltungen auch entsprechende Potentialabsenkungen an den Inverterausgängen e' und e".

Ist nun, wie dies in FIG 2e mit einer durchgehenden Linie verdeutlicht ist, zu dieser Zeit am Schaltungseingang e (in FIG 1) ein "1"-Eingangssignalpegel etwa von +2 Volt gegeben, aufgrund dessen der Eingangssignaltransistor Tne der Ansteuerschaltung A leitend ist, so weist die Parallelschaltung aus der Transistor-Serienschaltung Tnt', Tne und dem weiteren n-Kanal-Transistor Tn' einen niedrigeren Widerstand auf als der weitere n-Kanal-Transistor Tn", so daß, nachdem die beiden Lasttransistoren Tpb' und Tpb" gleich stark ausgesteuert und daher in gleichem Ausmaße leitend sind, der über den Verbindungspunkt v' fließende Strom größer ist als der über den Verbindungspunkt v" fließende Strom. Die Potentialabsenkung am Inverterausgang e' ist daher kräftiger als diejenige am Inverterausgang e" mit der Folge eines entsprechend kräftigeren Nichtleitendwerdens des mit seiner Gate-Elektrode am Inverterausgang e' liegenden Treibertransistors Tnb", was den über den Verbindungspunkt v" fließenden Strom weiter kleiner als den über den Verbindungspunkt v' fließenden Strom hält. Es sei bemerkt, daß, obwohl über den Verbindungspunkt v" der kleinere Strom fließt, wegen der Ansteuerung der beiden Treibertransistoren Tnb" und Tnb' vom jeweils anderen Inverterausgang e' bzw. e" her das Potential am Verbindungspunkt v" genauso kräftig absinkt wie das Potential am Inverterausgang e', während umgekehrt das Potential am Verbindungspunkt v' dem Potential am Inverterausgang e" folgt.

Übersteigt das Potential an den Taktsignaleingängen t das Potential des Verbindungspunktes v" um mehr als die Schwellenspannung des Verstärkertransistors Tn, so wird dieser Transistor leitend, wobei seine Drain-Elektrode beim Verbindungspunkt v' und seine Source-Elektrode beim Verbindungspunkt v" liegt. Dies hat zur Folge, daß der über den Verbindungspunkt v" fließende, ohnehin schon kleinere Strom nunmehr zum größten Teil vom Treibertransistor Tnb' her gezogen und somit dem bisher schon über den Verbindungspunkt v' fließenden, größeren Strom noch überlagert wird, wodurch das Potential an dem einen Inverterausgang e' weiter absinkt, während das Potential am anderen Inverterausgang e" wieder ansteigt. Die beiden Verbindungspunkte v' und v" gelangen durch den leitenden Verstärkertransistor Tn auf gleiches Potential, das durch die Haltetransistoren Tn' und Tn" weiter zum (Masse-)- Potential $U_{SS}$ gezogen wird. Die kreuzgekoppelten C-MOS-Inverterschaltungen Tpb', Tnb' und Tpb", Tnb" sind nunmehr zum bistabilen Kippglied wirksam zusammengeschaltet; dieses bistabile Kippglied kippt vom labilen Zustand in einen stabilen Zustand, wobei das Potential an dem einen Inverterausgang e' gemäß FIG 2e' auf den Wert $U_{SS}$ (Masse) gelangt und das Potential am anderen Inverterausgang e" gemäß FIG 2e" auf den Wert $U_{DD}$ (+5 Volt).

In der Leistungsstufe LS sind dann der p-Kanal-Transistor Tpl' der einen C-MOS-Inverterschaltung Tpl', Tnl' und der n-Kanal-Transistor Tnl" der anderen C-MOS-Inverterschaltung Tpl", Tnl" leitend und der n-Kanal-Transistor Tnl' der einen C-MOS-Inverterschaltung und der p-Kanal-Transistor Tpl" der anderen C-MOS-Inverterschaltung nicht leitend; am Ausgang a' der Schaltungsanordnung tritt dann gemäß FIG 2a' das "1"-Signal-Potential $U_{DD}$ von im Beispiel 5 Volt auf und am Ausgang a" gemäß FIG 2a" das (Masse-)Potential $U_{SS}$.

Ist dagegen, wie dies in FIG 2e gestrichelt dargestellt ist, zu der Signalübernahmezeit am Schaltungseingang e (in FIG 1) ein "0"-Eingangssignalpegel etwa von 0,8 Volt über $U_{SS}$ gegeben, so daß der Eingangssignaltransistor Tne der Ansteuerschaltung A nichtleitend ist, und weist daher die Parallelschaltung aus dem Haltetransistor Tn' und der Serienschaltung von Eingangssignaltransistor Tne und Abtasttransistor Tnt' einen höheren Widerstand als der weitere Haltetransistor Tn" auf, so kommt es in einer den vorstehend erläuterten Vorgängen spiegelbildlich entsprechenden Weise zu einem Übergang des wirksamwerdenden bistabilen Kippgliedes B von seinem labilen Zustand in den anderen stabilen Zustand, in dem, wie dies in FIG 2 gestrichelt dargestellt ist, am Inverterausgang e' gemäß FIG 2e' das $U_{DD}$ -Potential und am Inverterausgang e" gemäß FIG 2e" das $U_{SS}$ -Potential auftritt und in entsprechender Weise am Schaltungsausgang a' gemäß FIG 2a' das (Masse-)Potential $U_{SS}$ und am Schaltungsausgang a" gemäß FIG 2a" das $U_{DD}$ -Potential (+5 Volt).

Die dynamische Signalumsetzschaltung gemäß FIG 1 gestattet die mit der jeweils einen Taktflanke eines einzigen Taktsignals t (in FIG 2t) vor sich gehende Signalübernahme auch von kleinhubigen, mit ihrem Pegel etwas über der etwa bei 0,5 bis 1,2 Volt liegenden Schwellenspannung des n-Kanal-Eingangssignaltransistors Tne liegenden "1"-Eingangssignalen und besitzt somit eine hohe Empfindlichkeit; gleichzeitig weist die Signalumsetzschaltung auch eine hohe Einstellgeschwindigkeit auf: Nach Ablauf einer kurzen, im Bereich von etwa 10 Nanosekunden und weniger liegenden Einstellzeit, die sich aus einer Signal-Set-up-Zeit $t_{su}$, der Taktflankendauer $t_f$ und einer Signal-Hold-Zeit $t_h$ (siehe FIG 2t) zusammensetzt, ist die Signalumsetzschaltung A, B, LS in den dem jeweiligen Eingangssignal e (in FIG 2e) entsprechenden Signalzustand eingelaufen und ist damit das jeweilige Eingangssignal e (in FIG 2e) übernommen.

Dabei kann das Eingangssignal am Schaltungseingang e (in FIG 1) wieder abgetrennt bzw. geändert werden, sobald die Verbindungspunkte v' und v" zwischen dem als solches wirksamwerdenden bistabilen Kippglied B und der danach als Quasi-Masse wirkenden Ansteuerschaltung A auf gleiches Potential gelangt sind, d.h. noch während des Kippvorganges des bistabilen Kippgliedes. Zu diesem Zeitpunkt ist das bistabile Kippglied B bereits ausreichend stabil, da die über die beiden Verbindungspunkte v' und v" fließenden Ströme praktisch nur noch über den einen Zweig des bistabilen Kippgliedes geleitet werden. Sobald so das Eingangssignal übernommen ist, wird es nicht mehr benötigt; die Signalübernahmeschaltung kann durch entsprechendes Absenken des Taktsignalpegels gemäß FIG 2t vom Potentialwert $U_{DD}$ auf den Potentialwert $U_{SS}$ in den Vorbereitungszustand zurückgeschaltet werden.

In dem im Vorstehenden erläuterten Ausführungsbeispiel gemäß FIG 1, das bei unterschiedlicher Dimensionierung der beiden Haltetransistoren Tn' und Tn" nur bei dem Transistor Tn' höheren Kanalwiderstandes die Parallelschaltung zweier untereinander in Serie geschalteter MOS-Transistoren, nämlich des Eingangssignaltransistors Tne und des Abtasttransistors Tnt', vorsieht, ist eine einfache Ansteuerung der Ansteuerschaltung A nur mit dem Eingangssignal vorgesehen. Die Signalumsetzschaltung gemäß der Erfindung kann in einfacher Weise auch an andere gebräuchliche Ansteuerbedingungen angepaßt werden, indem die Ansteuerschaltung A entsprechend modifiziert wird. Dazu kann in Abweichung von dem Ausführungsbeispiel gemäß FIG 1 die Ansteuerschaltung in der aus FIG 5 ersichtlichen Weise so ausgebildet sein, daß bei nunmehr gleich dimensionierten Haltetransistoren Tn' und Tn" auch dem Haltetransistor Tn" eine Serienschaltung aus einem taktsignalgesteuerten MOS-Transistor Tnt" und einem nunmehr zusatzsignalgesteuerten MOS-Transistor Tnz parallelgeschaltet ist.

Dabei kann der zusatzsignalgesteuerte MOS-Transistor Tnz von einem Zusatzsignaleingang z her an seiner Gate-Elektrode durch ein externes Referenzsignal gesteuert sein, wenn es darum geht, das am Schaltungseingang e auftretende Eingangssignal mit einem solchen, einen Entscheidungspegel definierenden Referenzsignal zu vergleichen.

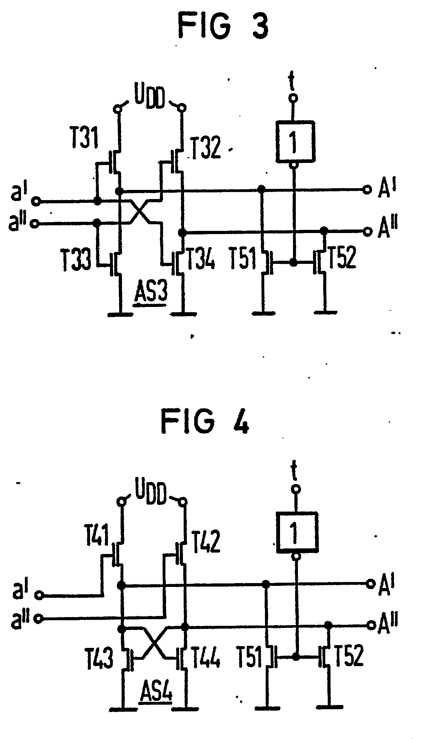

Liegt das Eingangssignal auch als Komplementärsignal vor, so kann die Ansteuerschaltung A gemäß FIG 3 an dem Zusatzsignaleingang z auch mit dem negierten Eingangssignal beaufschlagt sein.

Die in FIG 1 skizzierte Signalumsetzschaltung, in der die an den beiden C-MOS-Inverterausgängen e' und e" auftretenden großhubigen C-MOS-Signale (FIG 2e' und FIG 2e"), in die das am Signaleingang e (in FIG 1) auftretende, mit der (im Ausführungsbeispiel ansteigenden) einen Flanke des Taktsignals (FIG 2t) übernommene Eingangssignal (FIG 2e) umgesetzt wird, in der nachfolgenden Leistungsstufe LS jeweils invertiert und leistungsverstärkt werden, kann an ihren Ausgangsklemmen a', a" mit merklichen kapazitiven Ausgangslasten beschaltet werden, die je nach Dimensionierung etwa bis zu 3 pF gehen können. Für höhere kapazitive Ausgangsbelastungen wird zweckmäßigerweise der Leistungsstufe eine Ausgangs-Treiberstufe nachgeschaltet. Eine solche Ausgangsstufe kann, wie die in FIG 3 skizzierte Ausgangsstufe AS3, zwei mit den zwei C-MOS-Inverterschaltungen Tpl', Tnl' und Tpl", Tnl" (in FIG 1)

verbundene Einkanal-MOS-Gegentakt-Ausgangsschaltungen T31, T33 und T32, T34 aufweisen. Eine andere Möglichkeit zeigt FIG 4 mit einer Ausgangsstufe AS4, die zwei mit den zwei C-MOS-Inverterschaltungen der Leistungsstufe LS (in FIG 1) verbundene Einkanal-MOS-Sourcefolger-Ausgangsschaltungen T41, T43 und T42, T44 mit Flip-Flop-Rückkopplung ihrer Treibertransistoren T43 und T44 aufweist.

In beiden Fällen kann, wie dies auch in FIG 3 und FIG 4 skizziert ist, ein an dem einen Ausgang dem einen Signalzustand entsprechendes Ausgangssignal (Massepotential) über zwei mit dem negierten Taktsignal gesteuerte Schalttransistoren T51, T52 gleichzeitig beiden Komplementärausgängen A', A" aufgeprägt werden.

Die Erfindung, die immer dort Anwendung finden kann, wo kleinhubige Eingangssignale in großhubige Signale hoher Belastbarkeit umgesetzt werden müssen, wie dies etwa beim Ansteuern von C-MOS-Bausteinen mit TTL- bzw. ECL-Signalen der Fall sein kann, wurde im Vorstehenden anhand eines Ausführungsbeispiels erläutert, das zwischen den n-Kanal-Transistoren der beiden zu einem bistabilen Kippglied B zusammenschaltbaren C-MOS-Inverterschaltungen und der zugehörigen Speisepotentialquelle $U_{SS}$ eine Ansteuerschaltung A vorsieht. Es sei indessen bemerkt, daß abweichend davon auch eine dann mit p-Kanal-Transistoren aufgebaute Ansteuerschaltung zwischen den p-Kanal-Transistoren der beiden C-MOS-Inverterschaltungen und der zugehörigen Speisepotentialquelle $U_{DD}$ (in FIG 1) vorgesehen sein kann, wobei die Übernahme eines Eingangssignals dann mit der fallenden Taktsignalflanke vor sich geht, ohne daß dies hier indessen noch weiter ins Einzelne gehend erläutert werden müßte.

Bezugszeichenliste

a', a" Schaltungsausgänge
A Ansteuerschaltung
A', A" Schaltungsausgänge
AS3 Ausgangsstufe
AS4 Ausgangsstufe
B Bistabiles Kippglied
e Schaltungseingang
e', e" (Inverter-)Ausgänge, (Inverter-)Ausgangssignale
LS Leistungsstufe
t Takteingang, Taktsignal
$t_{su}$ Signal-set-up-Zeit
$t_f$ Taktflankendauer
$t_h$ Signal-hold-Zeit
Tn (Verstärker)Transistor
Tn' (Halte-)Transistor
Tn" (Halte-)Transistor
Tne eingangssignalgesteuerter MOS-Transistor, Eingangssignaltransistor
Tnt' taktsignalgesteuerter MOS-Transistor
Tnt" taktsignalgesteuerter MOS-Transistor
Tp' Schalttransistor
Tp" Schalttransistor
Tpb', Tnb' kreuzgekoppelte C-MOS-Inverterschaltungen
Tpb", Tnb" kreuzgekoppelte C-MOS-Inverterschaltungen
Tpb', Tpb" Lasttransistoren
Tnb', Tnb" Treibertransistoren
Tnz Zusatzsignalgesteuerter MOS-Transistor
T31, T33 Einkanal-MOS-Gegentakt-Ausgangsschaltungen
T32, T34 Einkanal-MOS-Gegentakt-Ausgangsschaltungen
T41, T43 Einkanal-MOS-Sourcefolger-Ausgangsschaltungen
T42, T44 Einkanal-MOS-Sourcefolger-Ausgangsschaltungen
T43 Treibertransistor
T44 Treibertransistor
T51 Schalttransistor
T52 Schalttransistor
$U_{DD}$ Betriebsspannungsquelle, Betriebsspannungsklemmen
$U_{SS}$ Speisepotentialquelle (Masse), Betriebsspannungsklemmen
$U_T$ Schwellenspannung
v', v" Verbindungspunkte
z Zusatzsignaleingang

**Patentansprüche**

1. Schaltungsanordnung zur Umsetzung von kleinhubigen Eingangssignalen in großhubige Ausgangssignale mit einer Flip-Flop-Schaltung (B) und einer Taktsteuerschaltung (A), durch die taktflankengesteuert und ein dem Binärwert eines Eingangssignals entsprechender Zustand der Flip-Flop-Schaltung (B) eingestellt wird, wobei der Flip-Flop-Schaltung (B) eine Leistungsstufe (LS) mit zwei C-MOS-Inverterschaltungen (Tpl', Tnl'; Tpl'', Tnl'') nachgeschaltet ist, insbesondere zum Ansteuern von C-MOS-Bausteinen mit TTL- oder ECL-Signalen, gekennzeichnet durch zwei kreuzgekoppelte C-MOS-Inverterschaltungen (Tpb', Tnb'; Tpb'', Tnb''),
   – an deren zwei Ausgänge (e', e'') die eine Speisepotentialquelle (U$_{DD}$) auch gleichzeitig über zwei gleichsinnig taktsignalgesteuerte Schalttransistoren (Tp'; Tp'') des einen Kanaltyps anschaltbar ist,
und eine zwischen deren zwei Transistoren (Tnb'; Tnb'') des anderen Kanaltyps und die andere Speisepotentialquelle (U$_{SS}$) eingefügte Ansteuerschaltung (A) mit
   – zwei weiteren, zwischen diese Transistoren (Tnb'; Tnb'') und die Speisepotentialquelle (U$_{SS}$) eingefügten Transistoren (Tn'; Tn'') gleichen Typs,
   – einer dem einen (Tn') dieser zwei weiteren Transistoren parallelgeschalteten Serienschaltung aus einem eingangssignalgesteuerten MOS-Transistor (Tne) gleichen Typs und einem taktsignalgesteuerten MOS-Transistor (Tnt') gleichen Typs
   – und einem zwischen den zwei Verbindungspunkten (v'; v'') der zwei kreuzgekoppelten C-MOS-Inverterschaltung (Tpb', Tnb'; Tpb', Tnb'') und der Ansteuerschaltung (A) eingefügten Transistor (Tn) gleichen Typs, über den die zwei kreuzgekoppelten C-MOS-Inverterschaltungen zu einem bistabilen Kippglied zusammenschaltbar sind.

2. Schaltungsanordnung nach Anspruch 1, **dadurch gekennzeichnet**, daß bei unterschiedlicher Dimensionierung der genannten zwei weiteren Transistoren (Tn'; Tn'') dem Transistor (Tn') höheren Kanalwiderstands die genannte Serienschaltung zweier MOS-Transistoren (Tne und Tnt') parallelgeschaltet ist.

3. Schaltungsanordnung nach Anspruch 1, **dadurch gekennzeichnet**, daß bei gleicher Dimensionierung der genannten zwei weiteren Transistoren (Tn'; Tn'') dem anderen (Tn'') dieser zwei Transistoren eine Serienschaltung aus einem zusatzsignalgesteuerten MOS-Transistor gleichen Typs (Tnz) und einem taktsignalgesteuerten MOS-Transistor (Tnt'') gleichen Typs parallelgeschaltet ist.

4. Schaltungsanordnung nach Anspruch 3, **dadurch gekennzeichnet**, daß der zusatzsignalgesteuerte MOS-Transistor (Tnz) durch ein Referenzsignal gesteuert wird.

5. Schaltungsanordnung nach Anspruch 3, **dadurch gekennzeichnet** daß der zusatzsignalgesteuerte MOS-Transistor (Tnz) durch das negierte Eingangssignal gesteuert wird.

6. Schaltungsanordnung nach einem der Ansprüche 1 bis 5, **dadurch gekennzeichnet**, daß der Leistungsstufe (LS) eine Ausgangsstufe (AS3) mit zwei mit den genannten zwei weiteren C-MOS-Inverterschaltungen (Tpl', Tnl'Tpl'', Tnl'') verbundenen Einkanal-MOS-Gegentakt-Ausgangsschaltungen (T31,T33; T32, T34) nachgeschaltet ist.

7. Schaltungsanordnung nach einem der Ansprüche 1 bis 5, **dadurch gekennzeichnet**, daß der Leistungsstufe (LS) eine Ausgangsstufe (AS4) mit zwei mit den genannten zwei weiteren C-MOS-Inverterschaltungen (Tpl', Tnl'; Tpl'', Tnl'') verbundenen Einkanal-MOS-Sourcefolger-Ausgangsschaltungen (T41, T43; T42; T44) mit Flip-Flop-Rückkopplung ihrer Treibertransistoren (T43; T44) nachgeschaltet ist.

8. Schaltungsanordnung nach Anspruch 7 oder 8, **dadurch gekennzeichnet**, daß ihren beiden Komplementärausgängen (a',a'', A', A'') gleichzeitig das dem einen Signalzustand entsprechende Ausgangssignal über zwei mit dem negierten Taktsignal gesteuerte Schalttransistoren (T51, T52) aufprägbar ist.

**Claims**

1. Circuit arrangement for the translation of low-deviation input signals into high-deviation output signals having a flip-flop circuit (B) and a clock-control circuit (A), by which a state of the flip-flop circuit (B) corresponding to the binary value of an input signal is set under clock edge control, the flip-flop circuit (B) being followed by a power stage (LS) having two C-MOS inverter circuits (Tpl', Tnl'; Tpl'', Tnl''), in particular for the activation of C-MOS chips by TTL or ECL signals, characterized by two cross-coupled C-MOS inverter circuits (Tpb', Tnb'; Tpb'', Tnb''),
   – at the two outputs (e', e'') of which the one feed potential source (U$_{DD}$) can also be connected at the same time via two switching transistors (Tp'; Tp'') of the one channel type, clock-signal controlled in the same sense,
and an activation circuit (A), inserted between the two transistors (Tnb'; Tnb'') of the other channel type of the said inverter circuits and the other feed potential source (U$_{SS}$) and having
   – two further transistors (Tn'; Tn'') of the same type, inserted between these transistors (Tnb'; Tnb'') and the feed potential source (U$_{SS}$),
   – a series circuit, connected in parallel with the one (Tn') of these two further transistors and comprising an input-signal controlled MOS transistor (Tne) of the same type and a clock-signal controlled MOS transistor (Tnt') of the same type

– and a transistor (Tn) of the same type, inserted between the two connecting points (v′; v″) of the two cross-coupled C-MOS inverter circuits (Tpb′, Tnp′; Tpb″, Tnb″) and the activation circuit (A), via which transistor the two cross-coupled C-MOS inverter circuits can be connected together to form a bistable element.

2. Circuit arrangement according to Claim 1, characterized in that, in the case of different dimensioning of the said two further transistors (Tn′; Tn″), the said series circuit of two MOS transistors (Tne and Tnt′) is connected in parallel with the transistor (Tn′) of higher channel resistance.

3. Circuit arrangement according to Claim 1, characterized in that, in the case of the same dimensioning of the said two further transistors (Tn′; Tn″), a series circuit comprising an auxiliary-signal controlled MOS transistor of the same type (Tnz) and a clock-signal controlled MOS transistor (Tnt″) of the same type is connected in parallel with the other (Tn″) of these two transistors.

4. Circuit arrangement according to Claim 3, characterized in that the auxiliary-signal controlled MOS transistor (Tnz) is controlled by a reference signal.

5. Circuit arrangement according to Claim 3, characterized in that the auxiliary-signal controlled MOS transistor (Tnz) is controlled by the negated input signal.

6. Circuit arrangement according to one of Claims 1 to 5, characterized in that the power stage (LS) is followed by an output stage (AS3) having two single-channel MOS push-pull output circuits (T31, T33; T32, T34), connected to the said two further C-MOS inverter circuits (Tpl′, Tnl′; Tpl″, Tnl″).

7. Circuit arrangement according to one of Claims 1 to 5, characterized in that the power stage (LS) is followed by an output stage (AS4) having two single-channel MOS source-follower output circuits (T41, T43; T42, T44), connected to the said two further C-MOS inverter circuits (Tpl′, Tnl′; Tpl″, Tnl″) and having flip-flop feedback of their driver transistors (T43, T44).

8. Circuit arrangement according to Claim 7 or 8, characterized in that the output signal corresponding to the one signal state can be impressed on both its complementary outputs (a′, a″; A′, A″) at the same time via two switching transistors (T51, T52) controlled by the negated clock signal.

**Revendications**

1. Montage pour convertir des signaux d'entrée présentant une faible excursion en des signaux de sortie présentant une excursion élevée, comportant un circuit à bascule bistable (B) et un circuit de commande cadencée (A), qui règlent, d'une manière commandée par les flancs des impulsions de cadence, un état du circuit à bascule bistable (B), qui correspond à la valeur binaire d'un signal d'entrée, et dans lequel en aval du circuit à bascule bistable (B) est branché un étage de puissance (LS) comportant deux circuits inverseurs C-MOS (Tpl′, Tnl′; Tpl″, Tnl″), notamment pour la commande de modules C-MOS avec des signaux TTL ou ECL, caractérisé par deux circuits inverseurs C-MOS couplés selon un couplage croisé (Tpb′, Tnb′; Tpb″, Tnb″),

– aux deux sorties (e′, e″) desquels une source de potentiel d'alimentation (U_DD) peut être également raccordée simultanément par l'intermédiaire de deux transistors de commutation (Tp′; Tp″) possédant un premier type de canal et commandés dans le même sens par les signaux de cadence, et un circuit de commande (A) inséré entre deux transistors (Tnb′; Tnb″), possédant l'autre type de canal, des circuits inverseurs et l'autre source de potentiel d'alimentation (U_SS), et comportant

– deux autres transistors (Tn′; Tn″) du même type, insérés entre ces transistors (Tnb′, Tnb″) et la source de potentiel d'alimentation (U_SS),

– un circuit série branché en parallèle avec l'un (Tn′) de ces deux autres transistors et constitué par un transistor MOS (Tne) du même type, commandé par le signal d'entrée, et un transistor MOS (Tnt′) du même type, commandé par le signal de cadence, et

– un transistor (Tn) du même type, qui est inséré entre les deux points de jonction (v′; v″) des deux circuits inverseurs C-MOS couplés selon un couplage croisé (Tpb′, Tnb′; Tpb″, Tnb″) et le circuit de commande (A) et au moyen duquel les deux circuits inverseurs C-MOS couplés selon un couplage croisé sont interconnectés pour former un circuit à bascule bistable.

2. Montage suivant la revendication 1, caractérisé par le fait que, dans le cas d'un dimensionnement différent desdits deux autres transistors (Tn′; Tn″), ledit circuit série formé de deux transistors MOS (Tne et Tnt′) est branché en parallèle avec le transistor (Tn′), dont la résistance du canal est la plus élevée.

3. Montage suivant la revendication 1, caractérisé par le fait que dans le cas d'un dimensionnement identique desdits deux autres transistors (Tn′; Tn″), en parallèle avec l'autre (Tn″) de ces deux transistors est branché un circuit série formé d'un transistor MOS du même type (Tnz), commandé par un signal additionnel, et d'un transistor MOS (Tnt″) du même type, commandé par le signal de cadence.

4. Montage suivant la revendication 3, caractérisé par le fait que le transistor MOS (Tnz) commandé par un signal supplémentaire est commandé par un signal de référence.

5. Montage suivant la revendication 3, caractérisé par le fait que le transistor MOS (Tnz) commandé par un signal additionnel est commandé par le signal d'entrée négative.

6. Montage suivant l'une des revendications 1 à 5, caractérisé par le fait qu'un étage de sortie (AS3), qui comporte deux circuits de sortie push-pull MOS à un canal (T31, T33; T32, T34) relié auxdits deux autres circuits inverseurs C-MOS (Tpl', Tnl'; Tpl", Tnl") est branché en aval de l'étage de puissance (LS).

7. Montage suivant l'une des revendications 1 à 5, caractérisé par le fait que l'étage de sortie (AS4) comportant deux circuits de sortie MOS à un canal montés en émetteurs suiveurs (T41, T43; T42, T44), qui sont reliés auxdits deux autres circuits inverseurs C-MOS (Tpl', Tnl'; Tpl", Tnl") et dont les transistors d'attaque (T43; T44) sont couplés par réaction pour former une bascule bistable, est branché en aval de l'étage de puissance (LS).

8. Montage suivant la revendication 6 ou 7, caractérisé par le fait que simultanément le signal de sortie correspondant à un état du signal peut être appliqué sur les deux sorties complémentaires (a', a"; A', A") par l'intermédiaire de deux transistors de commutation (T51, T52) commandés par le signal de cadence négativé.

# FIG.1

# FIG 5

FIG 2

# FIG 3

# FIG 4